(19) **Europäisches Patentamt**
**European Patent Office**
**Office européen des brevets**

(11) **EP 4 746 295 A1**

(12) # EUROPEAN PATENT APPLICATION

(43) Date of publication:
**20.05.2026 Bulletin 2026/21**

(21) Application number: **25211615.7**

(22) Date of filing: **28.10.2025**

(51) International Patent Classification (IPC):
***H03K 3/84*** *(2006.01)*

(52) Cooperative Patent Classification (CPC):
**H03K 3/84**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.10.2024 US 202463713513 P
19.08.2025 US 202519303451**

(71) Applicant: **Avago Technologies International
Sales
Pte. Limited
Singapore 768923 (SG)**

(72) Inventors:
• **Samavati, Behzad**
**Santa Ana, 92706 (US)**
• **Vakilian, Kambiz**
**Irvine, 92603 (US)**

(74) Representative: **Dilg, Haeusler, Schindelmann
Patentanwaltsgesellschaft mbH
Leonrodstraße 58
80636 München (DE)**

(54) **APPARATUS FOR SPREAD SPECTRUM CLOCK GENERATION**

(57)    A multiplexer including a plurality of inputs, an output and a plurality of terminals. The plurality of inputs receives a group of clocks from a plurality of signal lines. One of the signal lines is an allocated signal line. The allocated signal line transfers an input clock to the multiplexer. The output routes the input clock onto a clock line. One of the clocks is the input clock. The plurality of terminals receives control bits from a plurality of select lines. The multiplexer selects the allocated signal line from the signal lines according to a binary value of the control bits. The binary value of the control bits is adjusted during consecutive time slots.

**FIG. 4 – Frequency Multiplexing**

EP 4 746 295 A1

## Description

## BACKGROUND

Electromagnetic Compatibility (EMC) standards are regulatory guidelines that define the acceptable levels of electromagnetic emissions from an electronic device. The purpose of the EMC standards is to safeguard against excessive electromagnetic emissions from electronic devices that could interfere with the other electronic circuits and devices.

## BRIEF DESCRIPTION OF DRAWINGS

The accompanying drawings, which are incorporated in and form a part of this specification, illustrate examples of the disclosure and, together with the description, explain principles of the examples.

FIG. 1 illustrates exemplary power spectral density curves, in accordance with one or more embodiments of the disclosure.

FIGS. 2A, 2B and 2C illustrates an exemplary clock generator, in accordance with one or more embodiments of the disclosure.

FIG. 3 illustrates phase multiplexing, in accordance with one or more embodiments of the disclosure.

FIG. 4 illustrates frequency multiplexing, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

## DETAILED DESCRIPTION OF THE INVENTION

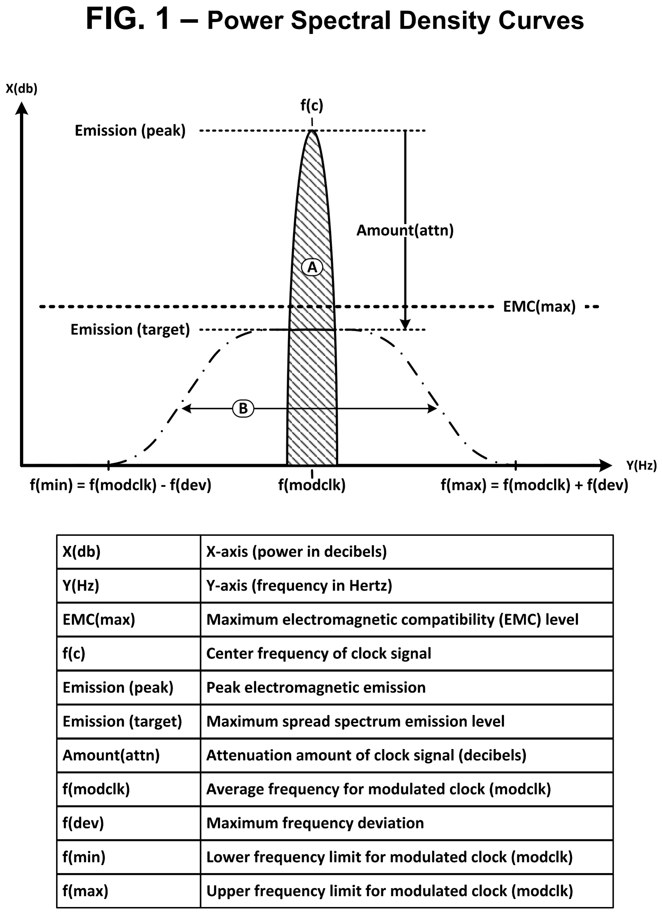

The following describes technical solutions in this specification with reference to the accompanying drawings. Exemplary embodiments are described in detail with reference to the accompanying drawings.
The terminology used herein is for describing various examples only, and is not to be used to limit the disclosure. Unless otherwise defined, all terms, including technical and scientific terms, used herein have the same meaning as commonly understood by one of ordinary skill in the art to which this disclosure pertains and after an understanding of the disclosure of this application.
Terms, such as those defined in commonly used dictionaries, are to be interpreted as having a meaning that is consistent with their meaning in the context of the relevant art and the disclosure of this application. Although the present technology has been described by referring to certain examples, workers skilled in the art will recognize that changes may be made in form and detail without departing from the scope of the discussion.
Referring to FIG. 1, power spectral density curves (A) and (B) are illustrated. The power spectral density curves depict the power distribution of signals across a range frequencies. In the example of FIG. 1, the X-axis "X(db)" represents power in decibels. The Y-axis "Y(Hz)" represents frequency in hertz. The Y-axis may present the frequency on a logarithmic scale.
In some instances, the EMC standards could designate a maximum permissible level of electromagnetic emission from an electronic device. Regulatory guidelines in the EMC standards that define the acceptable levels of electromagnetic emissions could also specify the power level for EMC(max). Illustrated by the example of FIG. 1, the EMC standards could specify EMC(max) as the maximum permissible level of electromagnetic emission from the electronic device in selected operational environments. Electromagnetic emissions from the electronic device that are below EMC(max) ensure that actions performed by electronic devices could occur in those operational environments without producing excessive electromagnetic radiation that interfere with other devices.
Some electronic devices in the art could produce a narrowband clock for synchronizing electronic components that are internal or external to the electronic devices. On some occasions, a major source of electromagnetic emission could be the transitioning of the narrowband clock with the electromagnetic emission produced by the transitioning being concentrated on a fixed center frequency. For example, the hatched area of FIG. 1 represents a power spectral density for the narrowband clock with a peak electromagnetic emission of the narrowband clock being concentrated at a center frequency f(c). The peak electromagnetic emission of the narrowband clock for power spectral density curve (A) extends above EMC(max).

Due to the rapid voltage and current transitions of narrowband clocks in such electronic devices, generation of electromagnetic emission caused by the narrowband clocks could increase the likelihood of electromagnetic interference (EMI) that could affect nearby electronic circuits and devices. Reducing the electromagnetic emission from the electronic device often requires costly off-chip components such as decoupling capacitors, ferrite beads and heavy metal shields. Accordingly, there is a need in the art for an improved electronic device.

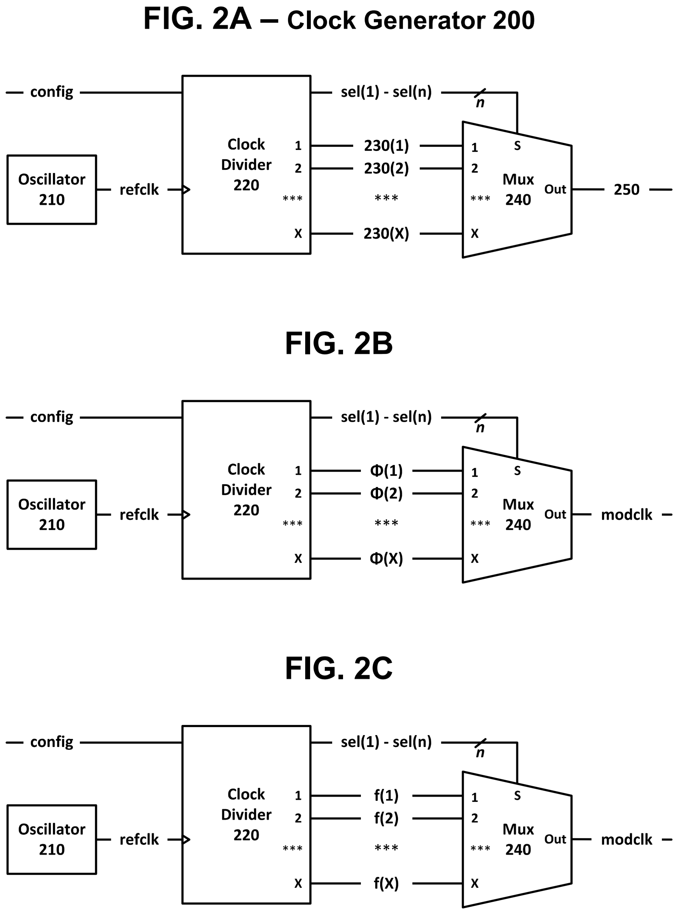

An improved electronic device may include clock generator 200. Clock generator 200 is circuitry designed to perform spread spectrum clock generation that may reduce any electromagnetic emissions attributed to a narrowband clock. In particular, clock generator 200 is configured to transform a reference clock (refclk) into a modulated clock (modclk), as will be explained in detail. Referring to FIGS. 2A, 2B and 2C, clock generator 200 is a component that may include oscillator 210, clock divider 220, signal lines 230 (1) - (X), mux 240 and clock line 250. "X" is the total number of signal lines 230. Those skilled in the art will appreciate there may be additional components in clock generator 200.

Oscillator 210 may exist as a component that is responsible for generating a stable and precise reference clock (refclk). Referred to herein, reference clock (refclk) may be any periodic waveform. A periodic waveform is a signal that repeats itself at regular intervals over time. Specifically, each cycle of the periodic waveform is a complete repetition of the signal that takes the same amount of time. Those skilled in the art will appreciate that reference clock (refclk) may exist in the form of a rectangular wave, a sine wave, a triangle wave, a sawtooth wave and/or any other periodic waveform.

Implemented as electronic hardware, clock divider 220 may include digital circuits, analog circuits or a combination of both digital and analog circuits. Analog circuits may include analog components that are suitable to process analog gate signals. Digital circuits may include switches and gates that are suitable to process digital gate signals.

Clock divider 220 may receive reference clock (refclk) from oscillator 210 and generate a group of clocks from reference clock (refclk). For example, clock divider 220 may perform division of reference clock (refclk) to generate the group of clocks, as will be explained in detail referring to FIGS. 2B and 2C. As such, the group of clocks is sourced from reference clock (refclk). Signal lines 230 (1) - (X) may transfer the group of clocks from clock divider 220 to mux 240. Referring to FIG. 2B, the group of clocks may include clocks Φ(1) - Φ(X). Alternatively, the group of clocks may include clocks f(1) - f(X) as in FIG. 2C.

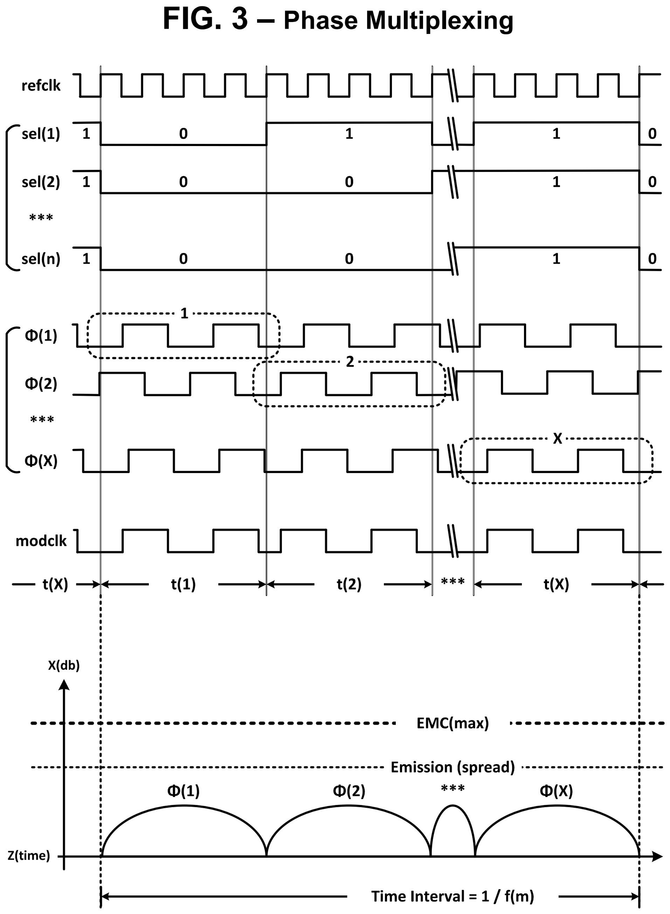

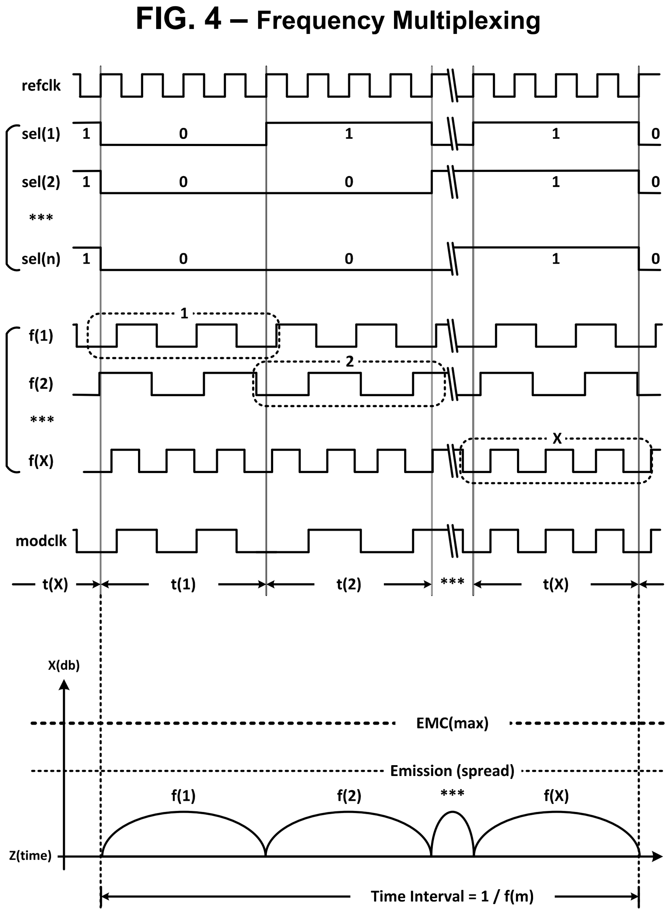

Clock divider 220 may govern a clock selection process. For example, clock divider 220 may cause mux 240 to perform a clock selection process that multiplexes one of several signal lines 230 (1) - (X) directly to a clock line 250. The clock selection process may end up being the phase multiplexing process of FIG. 3 in some instances. In other instances, the clock selection process may end up being the frequency multiplexing process of FIG. 4.

Illustrated by way of example of FIG. 1, the EMC standards could specify EMC(max) as the maximum permissible level of electromagnetic emission for modulated clock (modclk). By measuring the electromagnetic emission produced by the narrowband clock, the peak electromagnetic emission "emission (peak)" could be discovered. The EMC standards could also specify a maximum frequency deviation f(dev) from the average frequency of modulated clock (modclk).

In governing the clock selection process, clock divider 220 may receive one or more instructions (config) from a source external to clock generator 200. The one or more instructions (config) may provide operational parameters for clock divider 220. For example, clock divider 220 may extract user-customizable spectrum information from the operational parameters. In the spectrum information, a user may specify the average frequency f(m) for modulated clock (modclk) and the maximum frequency deviation f(dev) from the average frequency of modulated clock (modclk). Operational parameters in the spectrum information may specify the following relationships that contribute to shaping the profile for power spectral density curve (B):

$$\text{Amount(attn)} = 10 \times \log_{10}\left(\frac{\text{f(dev)}}{\text{f(m)}}\right) \qquad (1)$$

$$\text{Amount(attn)} = \text{emission(peak)} - \text{emission(target)} \qquad (2)$$

- Amount(attn): Attenuation amount of a narrowband clock;

- f(dev): Maximum frequency deviation from the average frequency of modulated clock (modclk);

- Emission (peak): Peak electromagnetic emission of a narrowband clock concentrated at frequency f(c);

- Emission (target): Target peak electromagnetic emission of modulated clock (modclk) resulting from spreading the spectrum emission level modulated clock (modclk).

By applying equations (1) and (2) those skilled in the art will appreciate that sufficient attenuation of electromagnetic emissions attributed to a narrowband clock from an electronic device may be attainable.

Clock divider 220 may extract user-customizable sequencing information from the operational parameters. A user may specify, in the sequencing information, the clock selection process as either the phase multiplexing process or the frequency multiplexing process. In response to processing the sequencing information, clock divider 220 may govern the clock selection process in accordance with the sequencing information either as the phase multiplexing process or as the frequency multiplexing process.

In some implementations, the group of clocks may include a phase-shifted array of clocks $\Phi(1) - \Phi(X)$ as illustrated by the examples of FIGS. 2B and 3. Referred to herein, "X" is an integer number whose value is the total number of signal lines 230. Clock divider 220 may process reference clock (refclk) to produce the phase-shifted array. Any of the clocks $\Phi(1) - \Phi(X)$ may exist simultaneously with all others of the clocks $\Phi(1) - \Phi(X)$. Each of the clocks $\Phi(1) - \Phi(X)$ are in synchronization with reference clock (refclk).

In the phase-shifted array, clocks $\Phi(1) - \Phi(X)$ are multi-phase clock signals. For example, any one of the clocks $\Phi(1) - \Phi(X)$ has the same frequency with while being out of phase with all other of the clocks $\Phi(1) - \Phi(X)$. All of the clocks $\Phi(1) - \Phi(X)$ are of the same frequency. The phase for any of the clocks $\Phi(2) - \Phi(X)$ is modulated to shift the instantaneous frequency any of the clocks $\Phi(2) - \Phi(X)$ around clock $\Phi(1)$. The larger the phase deviation from clock $\Phi(1)$, the more the frequency for any of the clocks $\Phi(2) - \Phi(X)$ will vary from the frequency for clock $\Phi(1)$. Each of the clocks $\Phi(1) - \Phi(X)$ in the phase-shifted array is shifted by a specific phase amount relative to others of the clocks $\Phi(1) - \Phi(X)$. Each of the clocks $\Phi(1) - \Phi(X)$ may exist simultaneously in parallel with all others of the clocks $\Phi(1) - \Phi(X)$.

In other implementations, the group of clocks may include a frequency-shifted array of clocks $f(1) - f(X)$ as illustrated by the examples of FIGS. 2C and 4. Clock divider 220 may process reference clock (refclk) to produce the frequency-shifted array. Each of the clocks $f(1) - f(X)$ in the frequency-shifted array is shifted by a specific frequency amount relative to others of the clocks $f(1) - f(X)$. Unlike a phase-shifted array where clocks $\Phi(1) - \Phi(X)$ have the same frequency with different phase offsets, clocks $f(1) - f(X)$ in the frequency-shifted array are shifted is frequency from one another. Any of the clocks $f(1) - f(X)$ may exist simultaneously with all others of the clocks $f(1) - f(X)$. Each of the clocks $f(1) - f(X)$ may exist simultaneously in parallel with all others of the clocks $f(1) - f(X)$.

Mux 240 is electronic circuitry implemented as any suitable multiplexer. Being a multiplexer, mux 240 may selectively, electrically connect one of several signal lines 230 (1) - (X) directly to clock line 250. In the example of FIG. 3, mux 240 may receive clocks $\Phi(1) - \Phi(X)$ by way of signal lines 230 (1) - (X). Alternatively, mux 240 may receive clocks $f(1) - f(X)$ by way of signal lines 230 (1) - (X) in the example of FIG. 4.

The user may specify, in the sequencing information, the total number of signal lines 230 (1) - (X) and the total number of select lines sel(1) - sel(n). Clock divider 220 may adjust the duty cycle for any of the select lines sel(1) - sel(n). In response to processing the sequencing information, clock divider 220 may ascertain the integer values for X" and "n." The relationship between "X" and "n" may be as follows:

$$X = 2^n \tag{3}$$

$$n = \log_2(X) \tag{4}$$

Referred to herein, "n" is an integer number that corresponds the total number of signal lines 230 (1) - (X). "X" may refer to the total number of signal lines 230 (1) - (X).

By way of illustration in the example of FIGS. 3 and 4, mux 240 may select one of the signal lines 230 (1) - (X) based on a binary value of the control bits on select lines sel(1) - sel(n) where a unique binary value corresponds to one of the signal lines 230 (1) - (X). Signals on select lines sel(1) - sel(n) may cause mux 240 to electrically connect one of several signal lines 230 (1) - (X) directly to clock line 250. The total number of select lines sel(1) - sel(n) is proportional to the total number of signal lines 230 (1) - (X).

The user may additionally specify, in the sequencing information, a choice between periodically multiplexing differing phases or frequencies of reference clock (refclk) and randomly multiplexing differing phases or frequencies of reference clock (refclk).

In response to processing the sequencing information in some instances, clock generator 200 may cause mux 240 to periodically multiplex differing phases or frequencies of reference clock (refclk) to generate modulated clock (modclk) under such conditions as illustrated in FIGS. 3 and 4. For example, in response to processing the sequencing information, clock divider 220 may adjust the binary value of the control bits on select lines sel(1) - sel(n) in such a way that causes mux 240 to select signal lines 230 (1) - (X) in a fixed, cyclic manner where each of the signal lines 230 (1) - (X) is allocated a specific time slot t(i) in binary order. "Binary order" is referred to herein as the selection of signal lines 230 (1) - (X) in a sequential binary counting pattern. The sequential binary counting pattern is a succession of binary numbers in which transitioning the least signification bit of a binary number may increment (or decrement) the binary numbers to the next value in the base-2 numbering system.

In response to processing the sequencing information in other instances, clock generator 200 may cause mux 240 to randomly multiplex differing phases or frequencies of reference clock (refclk) to generate modulated clock (modclk) under such conditions as illustrated in FIGS. 3 and 4. For example, in response to processing the sequencing information, clock divider 220 may adjust the binary value of the control bits for select lines sel(1) - sel(n) in such a way that causes mux 240 to select signal lines 230 (1) - (X) in a random manner where each of the signal lines 230 (1) - (X) is allocated the specific time slot t(i) in a non-deterministic order. A "non-deterministic order" is referred to herein as the selection of signal lines 230 (1) - (X) in a non-sequential binary counting pattern.

From the average frequency f(m) in the spectrum information, relationships may be as follows:

$$f(m) = \frac{1}{\sum_1^X t(i)} \sum_1^X t(i)\, freq(i) \tag{5}$$

$$\text{Time Interval} = \frac{1}{f(m)} \tag{6}$$

$$\text{Slot Duration} = \frac{\text{Time Interval}}{X} \tag{7}$$

where,

- X: The total number of signal lines 230;

- t(i): A time slot for multiplexing one of the clocks in the group onto clock line 250;

- freq(i): The frequency of the clock in the group that is multiplexed during time slot t(i);

- f(m): Average frequency for modulated clock (modclk);

- Time interval: The duration from the end of time slot (X) to the end of a consecutive time slot t(X);

- Slot duration: The length of time allocated to each time slot t(i).

Clock divider 220 may process equation (3) to calculate values for the time interval and the slot duration. In the examples of FIGS. 3 and 4, the Z-axis may present the time interval.

Referring to FIGS. 2A, 2B and 2C. mux 240 may include a plurality of inputs (1) - (X) that receives the group of clocks from signal lines 230 (1) - (X). Mux 240 may also include a plurality of terminals (S) that receives the control bits from select lines sel(1) - sel(n). Time slots t(1) - t(X) are illustrated in the example of FIGS. 3 and 4 as consecutive time slots t(i). With "X" being the total number of signal lines 230, the total number of time slots t(i) in a time interval may happen to be equal to the total number of signal lines 230 (1) - (X).

Clock divider 220 may adjust the binary value of the control bits on select lines sel(1) - sel(n) during consecutive time slots t(i). In some instance, clock divider 220 may adjust the binary value of the control bits on select lines sel(1) - sel(n) in such a way that causes mux 240 to select signal lines 230 (1) - (X) in a fixed, cyclic manner where each of the signal lines 230 (1) - (X) is allocated a specific time slot t(i) in binary order. For example, in FIGS. 3 and 4, the binary value of the control bits may change from "111" to "000" during a transition from time slot t(X) to time slot t(1) and may change from "000" to "001" during a transition from time slot t(1) to time slot t(2). Alternatively, in other instances, clock divider 220 may adjust the binary value of the control bits for select lines sel(1) - sel(n) in such a way that causes mux 240 to select signal lines 230 (1) - (X) in a random manner where each of the signal lines 230 (1) - (X) is allocated the specific time slot t(i) in a non-deterministic order.

Referring to FIG. 3, the binary value of the control bits on select lines sel(1) - sel(n) may cause mux 240 to select input (1) so as to allocate portion 1 of clock $\Phi(1)$ to time slot t(1) and to select input (2) so as to allocate portion 2 of clock $\Phi(2)$ to time slot t(2) during consecutive time slots t(i). The binary value of the control bits on select lines sel(1) - sel(n) may cause mux 240 to select input (X) so as to allocate portion X of clock $\Phi(X)$ to time slot t(X). Mux 240 may also select intervening inputs between inputs (2) - (X) so as to allocate portions of intervening clocks between clocks $\Phi(2)$ - $\Phi(X)$ to time slots between time slot t(2) and time slot t(X).

Referring to FIG. 4, the binary value of the control bits on select lines sel(1) - sel(n) may cause mux 240 to select input (1) so as to allocate portion 1 of clock f(1) to time slot t(1) and to select input (2) so as to allocate portion 2 of clock f(2) to time slot t(2) during consecutive time slots t(i). The binary value of the control bits on select lines sel(1) - sel(n) may cause mux 240 to select input (X) so as to allocate portion X of clock f(X) to time slot t(X). Mux 240 may also select intervening inputs between inputs (2) - (X) so as to allocate portions of intervening clocks between clocks f(2) - f(X) to time slots between time slot t(2) and time slot t(X).

Clock divider 220 may adjust the binary value of the control bits on select lines sel(1) - sel(n) in such a way that causes mux 240 to select one of the signal lines 230 (1) - (X) while simultaneously deselecting another of the signal lines 230 (1) - (X) only while the clocks on the deselected one of the signal lines 230 (1) - (X) and the selecting one of the signal lines 230 (1) - (X) are of the same logic value. For example, FIG. 3 illustrates a condition where clock $\Phi(1)$ and clock $\Phi(2)$ are both logic "0" during the transitioning from time slot t(1) to time slot t(2). FIG. 4 illustrates a condition where clock f(X) and clock f(1) are both logic "0" during the transitioning from time slot t(X) to time slot t(1). Although logic "0" is illustrated in both examples, the conditional requirement of a same logic value for clock divider 220 to adjust the binary value of the control bits on select lines sel(1) - sel(n) is equally applicable in cases where the logic value is logic "1". Clock divider 220 may delay adjusting the binary value until the conditional requirement of a same logic value exists.

Instead of generating a modulated clock (modclk) illustrated in the examples of FIGS. 2B and 2C, an electronic device could potentially generate a narrowband clock. In the absence of performing any of the clock selection processes illustrated in FIGS. 3 and 4, the electronic device may generate the narrowband clock having power spectral density curve (A) as illustrated in FIG. 1.

In contrast with power spectral density curve (A), power spectral density curve (B) in FIG. 1 is represented by a dot-dashed line. As illustrated by the examples of FIGS. 3 and 4, clock generator 200 may cause mux 240 to periodically multiplex differing phases or frequencies of reference clock (refclk) to generate modulated clock (modclk). Reference clock (refclk) may happen to be a square wave in the examples of FIGS. 3 and 4. However, those skilled in the art will appreciate that reference clock (refclk) may exist in the form of a rectangular wave, a sine wave, a triangle wave, a sawtooth wave and/or any other periodic waveform.

This periodic multiplexing of the differing phases or frequencies of reference clock (refclk) may allow for clock generator 200 to spread the clock spectrum of a narrowband clock under conditions that result in power spectral density curve (B) of FIG. 1. In such instances, clock generator 200 may attenuate the narrowband clock from a peak electromagnetic emission (emission (peak)) to a maximum spread the spectrum emission level (emission (spread)) as illustrated by the example of FIG. 1. Clock generator 200 may spread the clock spectrum of the narrowband clock in cases where clock generator 200 attenuates the narrowband clock. As a consequence of spreading the spectrum emission level (emission (spread)), clock generator 200 may reduce any electromagnetic emission that may result from the narrowband clock.

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a non-exclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, ordinal numbers (e.g., first, second, third, etc.) may be used as an adjective for an element (i.e., any noun in the application).

Although terms such as "first," "second," and "third" may be used herein to describe various members, components, regions, layers, or sections, these members, components, regions, layers, or sections are not to be limited by these terms.

Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology.

Rather, the use of ordinal numbers is to distinguish between the elements.

By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

## Claims

1. A component comprising:

   a multiplexer configured to:

      receive control bits from a plurality of select lines,
      receive a group of clocks from a plurality of signal lines, one of the signal lines being an allocated signal line, and
      route, from the allocated signal line, one of the clocks onto a clock line; and

   a clock divider configured to:
   cause, by adjusting a binary value of the control bits on the select lines, the multiplexer to select the allocated signal line while deselecting an additional one of the signal lines.

2. The component of claim 1, wherein
   the group of clocks is a phase-shifted array of clocks.

3. The component of claim 1 or 2, wherein
   the group of clocks is a frequency-shifted array of clocks.

4. The component of any one of the claims 1 to 3, wherein the clock divider is configured to:
   generate, in response to receiving a reference clock from an oscillator, the group of clocks from the reference clock.

5. The component of any one of the claims 1 to 4, wherein the clock divider is configured to:
   adjust the binary value of the control bits only while the clocks on the allocated signal line and the additional one of the signal lines are of a same logic value.

6. The component of any one of the claims 1 to 5, wherein
   the total number of time slots in a time interval is equal to the total number of signal lines.

7. The component of any one of the claims 1 to 6, wherein the clock divider is configured to:
   adjust the binary value of the control bits during a transitioning between consecutive time slots.

8. The component of claim 7, wherein

each of the time slots are of a slot duration;
wherein in particular
the slot duration is inversely proportional to the total number of the signal lines.

9. The component of any one of the claims 1 to 8, wherein the clock divider is configured to:
output the group of clocks to the multiplexer via the signal lines.

10. The component of any one of the claims 1 to 9, wherein
the allocated signal line is configured to transfer an input clock to the multiplexer.

11. The component of any one of the claims 1 to 10, wherein
the multiplexer is configured to select the allocated signal line from the plurality of signal lines according to the binary value of the control bits.

12. A multiplexer comprising:

a plurality of inputs configured to receive a group of clocks from a plurality of signal lines, one of the signal lines being an allocated signal line;
an output configured to route an input clock onto a clock line, one of the clocks being the input clock; and
a plurality of terminals configured to receive control bits from a plurality of select lines,
wherein the allocated signal line is configured to transfer the input clock to the multiplexer,
wherein the multiplexer is configured to select the allocated signal line from the plurality of signal lines according to a binary value of the control bits, and
wherein the binary value of the control bits is adjusted during consecutive time slots.

13. The multiplexer of claim 12, wherein
the total number of time slots in a time interval is equal to the total number of signal lines.

14. A method comprising:

receiving a group of clocks from a plurality of signal lines, one of the signal lines being an allocated signal line;
routing an input clock onto a clock line, one of the clocks being the input clock;
receiving control bits from a plurality of select lines; and
adjusting a binary value of the control bits during consecutive time slots,
wherein the allocated signal line transfers the input clock to a multiplexer, and
wherein the multiplexer selects the allocated signal line from the plurality of signal lines according to the binary value of the control bits.

15. The method of claim 14, wherein the method comprises at least one of the following features

(A) the group of clocks is a phase-shifted array of clocks;
(B) the group of clocks is a frequency-shifted array of clocks;
(C) the method further comprises:
causing, by adjusting the binary value of the control bits on the select lines, the multiplexer to select the allocated signal line while deselecting an additional one of the signal lines;
(D) the method further comprises:
generating, in response to receiving a reference clock from an oscillator, the group of clocks from the reference clock;
(E) the method further comprises:
adjusting the binary value of the control bits only while the clocks on the allocated signal line and an additional one of the signal lines are of a same logic value.

# FIG. 1 – Power Spectral Density Curves

| X(db) | X-axis (power in decibels) |
|---|---|
| Y(Hz) | Y-axis (frequency in Hertz) |
| EMC(max) | Maximum electromagnetic compatibility (EMC) level |
| f(c) | Center frequency of clock signal |
| Emission (peak) | Peak electromagnetic emission |
| Emission (target) | Maximum spread spectrum emission level |
| Amount(attn) | Attenuation amount of clock signal (decibels) |
| f(modclk) | Average frequency for modulated clock (modclk) |
| f(dev) | Maximum frequency deviation |
| f(min) | Lower frequency limit for modulated clock (modclk) |
| f(max) | Upper frequency limit for modulated clock (modclk) |

# FIG. 2A – Clock Generator 200

**config** — Clock Divider 220

Oscillator 210 — **refclk** → Clock Divider 220

Clock Divider 220:
- 1
- 2
- \*\*\*
- X

sel(1) - sel(n) — $n$

230(1) — 1
230(2) — 2
\*\*\* — \*\*\*
230(X) — X

Mux 240 — **Out** — 250

S

# FIG. 2B

**config** — Clock Divider 220

Oscillator 210 — **refclk** → Clock Divider 220

Clock Divider 220:
- 1
- 2
- \*\*\*
- X

sel(1) - sel(n) — $n$

$\Phi(1)$ — 1
$\Phi(2)$ — 2
\*\*\* — \*\*\*
$\Phi(X)$ — X

Mux 240 — **Out** — **modclk**

S

# FIG. 2C

**config** — Clock Divider 220

Oscillator 210 — **refclk** → Clock Divider 220

Clock Divider 220:
- 1
- 2
- \*\*\*
- X

sel(1) - sel(n) — $n$

f(1) — 1
f(2) — 2
\*\*\* — \*\*\*
f(X) — X

Mux 240 — **Out** — **modclk**

S

# FIG. 3 – Phase Multiplexing

# FIG. 4 – Frequency Multiplexing

## EUROPEAN SEARCH REPORT

Application Number

EP 25 21 1615

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/032899 A1 (BLUMER MARC [US]) 19 February 2004 (2004-02-19) | 1,2,4-15 | INV. H03K3/84 |
| A | * paragraph [0040] - paragraph [0042]; figures 4,5 * | 3 | |
| X | US 11 323 131 B2 (ST MICROELECTRONICS INT NV [CH]) 3 May 2022 (2022-05-03) | 1,2,4-15 | |
| A | * column 2, line 51 - column 3, line 44; figure 2 * | 3 | |
| X | US 2013/335151 A1 (SCHROM GERHARD [US] ET AL) 19 December 2013 (2013-12-19) | 1,3-15 | |
| A | * paragraph [0033] - paragraph [0035]; figure 9 * | 2 | |
| X | US 2005/134335 A1 (LOH KOU H [US] ET AL) 23 June 2005 (2005-06-23) | 1,3-15 | |
| A | * paragraph [0019] - paragraph [0024]; figure 1 * | 2 | |

| | TECHNICAL FIELDS SEARCHED (IPC) |
|---|---|
| | H03K |

The present search report has been drawn up for all claims

| Place of search | Date of completion of the search | Examiner |
|---|---|---|
| Munich | 23 March 2026 | Santos, Paulo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 1615

23-03-2026

| Patent document cited in search report | Publication date | Patent family member(s) | Publication date |
|---|---|---|---|
| US 2004032899 A1 | 19-02-2004 | US 6643317 B1<br>US 2004032899 A1 | 04-11-2003<br>19-02-2004 |
| US 11323131 B2 | 03-05-2022 | NONE | |
| US 2013335151 A1 | 19-12-2013 | CN 104221296 A<br>US 2013335151 A1<br>WO 2013147861 A1 | 17-12-2014<br>19-12-2013<br>03-10-2013 |
| US 2005134335 A1 | 23-06-2005 | NONE | |

EPO FORM P0459